# EUROPEAN PATENT SPECIFICATION

(11) **EP 3 848 769 B1**
(45) Date of publication and mention of the grant of the patent: **22.11.2023**
(21) Application number: 19858620.8
(22) Date of filing: 11.07.2019
(51) Int. Cl.: H01L 21/677, G05B 19/418

(54) **CONVEYANCE VEHICLE SYSTEM**
FÖRDERFAHRZEUGSYSTEM
SYSTÈME DE VÉHICULES DE TRANSPORT

(30) Priority: 04.09.2018 JP 2018165288
(43) Date of publication of application: 14.07.2021
(73) Proprietor: Murata Machinery, Ltd., Kyoto-shi, Kyoto 601-8326 (JP)
(72) Inventor: HARASAKI, Kazumi, Inuyama-shi, Aichi 484-8502 (JP)
(74) Representative: Stöckeler, Ferdinand
(86) International application number: PCT/JP2019/027597
(87) International publication number: WO 2020/049872

(56) References cited:
- WO-A1-2010/073475
- WO-A1-2017/090334
- WO-A1-2017/090334
- JP-A- 2006 221 309
- JP-A- 2006 313 463
- JP-A- 2011 022 974

## Description

### Technical Field

One aspect of the present invention relates to a transport vehicle system.

### Background Art

As a conventional transport vehicle system, a transportation carriage system is known, which includes a track provided in a manner extending over a plurality of areas, a plurality of overhead transport vehicles (transport vehicles) configured to travel in one direction along the track, a plurality of placement units (buffers) configured for each transport vehicle to deliver or receive an article thereto or therefrom, a plurality of area controllers (logic bay controllers) each configured to consider the corresponding one of the areas as a jurisdiction area and cause a transport vehicle in the jurisdiction area to execute various instructions, and a host controller (production controller) configured to transmit conveyance instructions to the area controllers (see Patent Document 1, for example).

WO 2017/090334A1 discloses a transport system including a track, overhead transport vehicles, and a controller. The controller provides a traveling command to travel to a destination point, to a first overhead transport vehicle that is able to receive a transport command to acquire a container from a station and that is less than a first distance from the station. When a second of the overhead transport vehicles that is able to receive the transport command and is less than the first distance from the station, is detected before providing the transport command to the overhead first transport vehicle, the controller provides the traveling command to the second overhead transport vehicle. Then, the controller provides the transport command to the one of the first and second overhead transport vehicles that first passes through the destination point.

WO 2010/073475 A1 discloses a carrying vehicle system provided with a route having a plurality of standby points, a plurality of carrying vehicles traveling on the route, and a carrying vehicle controller capable of allocating travel commands to the carrying vehicles. The carrying vehicle controller comprises a travel command allocation function allocating a travel command to make an unloaded carrying vehicle nearest to each standby point travel to the standby point.

JP 2011 022974 A discloses managing the number of vacant carrier vehicles in a carrier vehicle system on an area-by-area basis. The movement time of a carrier vehicle required for movement between areas is stored and a management unit is provided, which manages transport commands for moving vacant carrier vehicles between areas so as to avoid long waiting times.

### Citation List

### Patent Literature

[Patent Document 1] JP2009009365 A

### Summary of Invention

### Technical Problem

In the system configured to control various operations of the transport vehicles individually for the areas as described above, an area boundary exists between one jurisdiction area and another jurisdiction area different from the one jurisdiction area. In one jurisdiction area, a special section that cannot be entered without passing through another jurisdiction area may exist. If a conveyance instruction the conveyance source of which is a placement unit belonging to such a special section is issued, this conveyance instruction cannot be handled efficiently, and the handling time for a transport vehicle to reach the placement unit to be loaded with an article tends to increase.

In view of this, it is an object of one aspect of the present invention to provide a transport vehicle system that, even if a conveyance instruction the conveyance source of which is a placement unit belonging to a special section is issued, enables the conveyance instruction to be handled efficiently.

### Solution to Problem

The invention provides a transport vehicle system according to claim 1. Further developments of the invention are defined in the dependent claims.

A transport vehicle system according to one aspect of the present invention includes a track provided in a manner extending over a plurality of areas, a plurality of transport vehicles configured to travel in one direction along the track, a plurality of placement units disposed along the track and configured for each transport vehicle to deliver or receive an article to or from the placement units, a plurality of area controllers each configured to receive, from a host controller, a conveyance instruction to convey an article placed on one of the placement units in one of the areas representing a jurisdiction area associated with this area controller, and cause the transport vehicle in the jurisdiction area to execute various instructions. A placement unit belonging to a special section in one of the jurisdiction areas, which is a section that is unable to be entered without passing through another jurisdiction area different from the one jurisdiction area represents a special placement unit. Each area controller, when having received from the host controller a conveyance instruction destined for a special placement unit belonging to the own jurisdiction area that is the jurisdiction area associated with the area controller, transmits a movement instruction to cause an empty transport vehicle to move toward the own jurisdiction area to another area controller configured to control the transport vehicle in the other jurisdiction area, and also causes an empty transport vehicle that has become available in the own jurisdiction area after transmission of the movement instruction to execute the conveyance instruction.

There is a situation in which, even when having received a conveyance instruction the conveyance source of which is a special placement unit belonging to an own jurisdiction area, its area controller cannot immediately cause a transport vehicle to move to the special placement unit for loading. Thus, in a conventional transport vehicle system, the host controller transmits the conveyance instruction to another area controller having jurisdiction over another area, and this other area controller causes an empty transport vehicle in this other jurisdiction area to execute the conveyance instruction. However, in this case, even if an empty transport vehicle has become available in the special section of the own jurisdiction area before a transport vehicle in the other jurisdiction area reaches the special placement unit, the other area controller that has received the conveyance instruction cannot control the transport vehicle in the own jurisdiction area over which it has no jurisdiction. Thus, the transport vehicle in the own jurisdiction area has to pass by the special placement unit even though it is an empty transport vehicle. This causes a problem in which the conveyance efficiency deteriorates and the handling time increases. The term "empty transport vehicle" herein indicates a transport vehicle that is loaded with no article and can be loaded with (can convey) an article.

In view of this, in the transport vehicle system configured as described above, when a conveyance instruction the conveyance source of which is a special placement unit in one area has been issued, the host controller transmits the conveyance instruction to an area controller having jurisdiction over an area to which the special placement unit belongs first, instead of transmitting the conveyance instruction to an area controller of another area to which the special placement unit does not belong. The area controller that has received the conveyance instruction transmits, to another area controller, a movement instruction to cause an empty transport vehicle to move toward the own jurisdiction area. Thus, the area controller having jurisdiction over the area to which the special placement unit belongs can be given room to cause a transport vehicle in the own jurisdiction area to execute the conveyance instruction, whereby the conveyance instruction can be assigned to both of a transport vehicle (a transport vehicle in another jurisdiction area) that is going to enter the own jurisdiction area in accordance with the preceding movement instruction and an empty transport vehicle that becomes available in the own jurisdiction area. Consequently, deterioration of the conveyance efficiency described above can be eliminated, and, thus, even when a conveyance instruction the conveyance source of which is a placement unit belonging to a special section has been issued, this conveyance instruction can be handled efficiently.

In the transport vehicle system according to one aspect of the present invention, the empty transport vehicle in the own jurisdiction area to be detected by the area controller after the transmission of the movement instruction may be an empty transport vehicle that enters the own jurisdiction area from the other jurisdiction area or an empty transport vehicle that becomes available by placing an article onto a special placement unit belonging to the own jurisdiction area.

In the transport vehicle system according to one aspect of the present invention, the area controller may delete the movement instruction transmitted to the other area controller after causing the empty transport vehicle that has become available in the own jurisdiction area to execute the conveyance instruction. By this configuration, at the time when an empty transport vehicle has become available in the own jurisdiction area, movement of an empty transport vehicle traveling toward the own jurisdiction area can be canceled, and, thus, influence on the conveying capability in the other area can be minimized.

In the transport vehicle system according to one aspect of the present invention, the area controller may detect whether an empty transport vehicle is present in the own jurisdiction area before transmitting the movement instruction to the other area controller. By this configuration, before transmitting the movement instruction to the other area controller, necessity therefor can be checked, and thus influence on the conveying capability in the other area can be minimized.

In the transport vehicle system according to one aspect of the present invention, the area controller may detect whether an empty transport vehicle is present in the own jurisdiction area and upstream of the one special placement unit before transmitting the movement instruction to the other area controller. By this configuration, check range of the necessity to transmit the movement instruction to the other area controller can be minimized, whereby the handling speed can be improved.

### Advantageous Effects of Invention

According to one aspect of the present invention, even when a conveyance instruction the conveyance source of which is a placement unit belonging to a special section has been issued, the conveyance instruction can be handled efficiently.

### Brief Description of Drawings

[FIG. 1] FIG. 1 is a schematic plan view illustrating a transport vehicle system according to one embodiment.
[FIG. 2] FIG. 2 is a schematic side view illustrating a transport vehicle, a delivery port, and a buffer of the transport vehicle system in FIG. 1.
[FIG. 3] FIG. 3 is a plan view for describing a special section and non-special section in an area of the transport vehicle system in FIG. 1.
[FIG. 4] FIG. 4 is a sequence diagram of the transport vehicle system according to the embodiment.
[FIG. 5] FIG. 5 is a sequence diagram of the transport vehicle system according to the embodiment.
[FIG. 6] FIG. 6 is a sequence diagram of the transport vehicle system according to the embodiment.
[FIG. 7] FIG. 7 is a sequence diagram of the transport vehicle system according to the embodiment.

### Description of Embodiments

One preferred embodiment according to one aspect of the present invention will now be described in detail with reference to the drawings. In description of the drawings, like elements are designated by like reference signs, and duplicate description is omitted. The terms "upstream" and "downstream" used in the present embodiment mean upstream and downstream in a traveling direction in which overhead transport vehicles (transport vehicles) 6 move along a one-way (unidirectional) track 4.

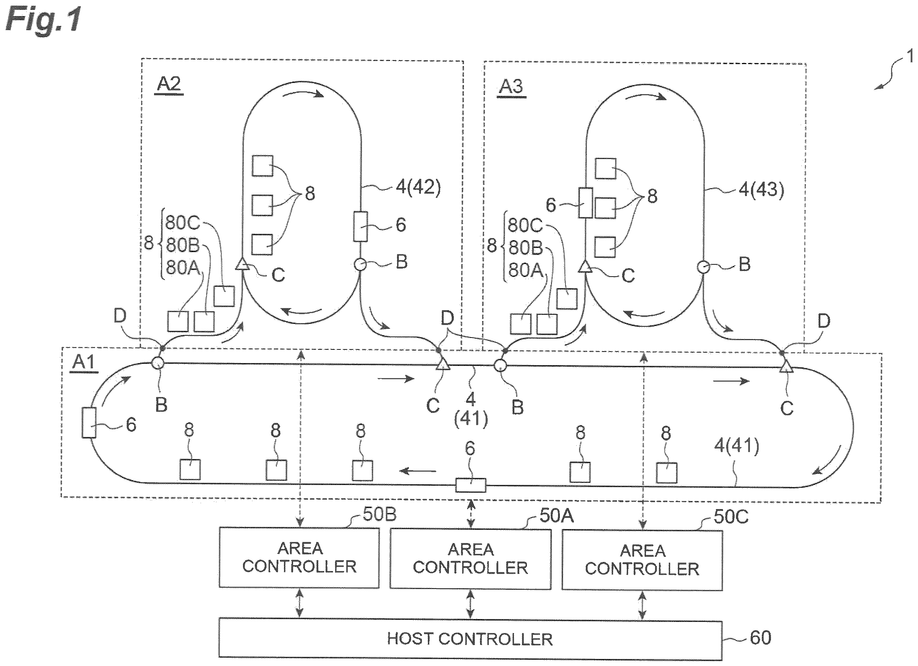

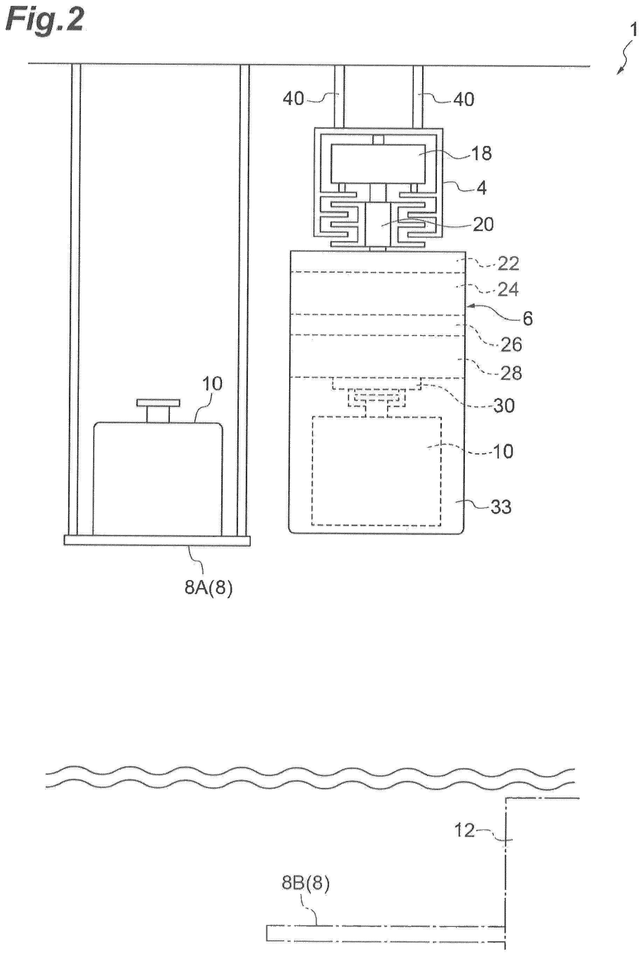

As illustrated in FIG. 1 and FIG. 2, a transport vehicle system 1 is a system configured to use the overhead transport vehicles 6 capable of moving along the track to convey articles 10 between placement units 8, 8. Examples of the articles 10 include containers such as a FOUP configured to store a plurality of semiconductor wafers and a reticle pod configured to store glass substrates, and general parts. The following describes an example of the transport vehicle system 1 in a factory, for example, in which the overhead transport vehicles 6 (hereinafter, simply called "transport vehicles 6") travel along the one-way track 4 installed on, for example, a ceiling of the factory. As illustrated in FIG. 1, the transport vehicle system 1 includes the track 4, the transport vehicles 6, a plurality of placement units 8, and a plurality of area controllers 50A, 50B, 50C.

The track 4 is provided in a manner extending over a plurality of areas A1, A2, A3. The track 4 is installed near the ceiling in a space overhead of an operator, for example. The track 4 is suspended from the ceiling, for example. The track 4 is a predetermined traveling path for the transport vehicles 6 to travel. The track 4 is supported by posts 40, 40.

Each transport vehicle 6 travels along the track 4 to convey an article 10. The transport vehicle 6 is configured to be able to transfer the article 10. The transport vehicle 6 is an overhead-traveling automated guided transport vehicle. The number of the transport vehicles 6 that the transport vehicle system 1 includes is not limited to a particular number, and is two or more.

As illustrated in FIG. 2, each transport vehicle 6 includes a traveling unit 18 configured to cause the transport vehicle 6 to travel along the track 4 and a power-receiving communication unit 20 configured to receive electric power from the track 4 by noncontact feeding, for example. The transport vehicle 6 uses a communication line (feeder line) of the track 4, for example, to communicate with any one of the area controllers 50A, 50B, 50C. Herein, the transport vehicle 6 may communicate with any one of the area controllers 50A, 50B, 50C via an electric supply line provided along the track 4. The transport vehicle 6 includes a body frame 22, a cross-feed unit 24, a θ drive 26, a lifting drive unit 28, a lifting platform 30, and a fall-prevention cover 33.

The cross-feed unit 24 laterally feeds the θ drive 26, the lifting drive unit 28, and the lifting platform 30 all together in a direction orthogonal to the traveling direction of the track 4. The θ drive 26 turns at least either one of the lifting drive unit 28 and the lifting platform 30 within a predetermined angle range in a horizontal plane. The lifting drive unit 28 winds or pays out suspending members such as wires, ropes, and belts, thereby raising or lowering the lifting platform 30. The lifting platform 30 is provided with a chuck so as to be able to hold or release an article 10. The fall-prevention cover 33 is provided in a pair to the front and the rear of the transport vehicle 6 in the traveling direction. The fall-prevention cover 33 extends and retracts claws (not illustrated), for example, to prevent the article 10 from falling during conveyance.

Each placement unit 8 to and from which a transport vehicle 6 delivers and receives an article 10 includes a buffer 8A and a delivery port 8B. The buffer 8A is a placement unit on which the article 10 is temporarily placed. For example, on the buffer 8A, an article 10 being conveyed by the transport vehicle 6 is temporarily put when the article 10 cannot be transferred onto a delivery port 8B as a destination for the reason that, for example, another article 10 has been placed on the delivery port 8B . The delivery port 8B is a placement unit for delivering and receiving an article 10 to and from a semiconductor processing device 12 including cleaning equipment, deposition equipment, lithography equipment, etching equipment, thermal treatment equipment, and planarization equipment. Herein, the processing device 12 is not limited to a particular one, and may be a device of various types or a stocker, for example.

Each placement unit 8 is disposed along the track 4, and is provided in a position where an article 10 can be delivered to and received from a transport vehicle 6. For example, the buffer 8A is disposed beside the track 4 (see FIG. 2). In this case, the transport vehicle 6 laterally feeds the lifting drive unit 28, for example, with the cross-feed unit 24 and slightly raises and lowers the lifting platform 30, thereby delivering and receiving the article 10 to and from the buffer 8A. Herein, the buffer 8A may be disposed directly below the track 4. For example, the delivery port 8B is disposed directly below the track 4 (see FIG. 2) . In this case, the transport vehicle 6 raises and lowers the lifting platform 30, thereby delivering and receiving the article 10 to and from the delivery port 8B. Herein, the delivery port 8B may be disposed beside and below the track 4.

The area controllers 50A, 50B, 50C are each an electronic control unit including a central processing unit (CPU), a read only memory (ROM), and a random access memory (RAM) . The area controllers 50A, 50B, 50C each can be configured as, for example, software such that a program stored in the ROM is loaded into the RAM to be executed by the CPU. The area controllers 50A, 50B, 50C each may be configured as hardware such as an electronic circuit.

The area controllers 50A, 50B, 50C are provided to the areas A1, A2, A3, respectively. The respective area controllers 50A, 50B, 50C are provided so as to correspond to the respective areas A1, A2, A3. Specifically, the area controllers 50A, 50B, 50C consider the areas A1, A2, A3 respectively as jurisdiction areas that are areas they themselves are in charge of controlling. In other words, one area controller considers one area as its jurisdiction area, and the number of area controllers corresponds to the number of areas. Thus, one area controller considers any one of the areas as its jurisdiction area.

The area controller 50A communicates with a plurality of transport vehicles 6 in the jurisdiction area A1 (hereinafter, also called "its own jurisdiction area A1") of the area controller 50A to control the transport vehicles 6 in its own jurisdiction area A1. In other words, the area controller 50A causes the transport vehicles 6 in the jurisdiction area A1 to execute various instructions. In the same manner as with the area controller 50A, the area controller 50B communicates with a plurality of transport vehicles 6 in its own jurisdiction area A2 to control the transport vehicles 6 in its own jurisdiction area A2. In the same manner as with the area controller 50A, the area controller 50C communicates with a plurality of transport vehicles 6 in its own jurisdiction area A3 to control the transport vehicles 6 in its own jurisdiction area A3. The area controllers 50A, 50B, 50C communicate with the host controller 60 by wire or radio.

The host controller 60 is an electronic control unit including a CPU, a ROM, and a RAM. The host controller 60 can be configured as, for example, software such that a program stored in the ROM is loaded into the RAM to be executed by the CPU. The host controller 60 may be configured as hardware such as an electronic circuit. The host controller 60 communicates with any one of the area controllers 50A, 50B, 50C by wire or radio, and transmits to any one of the area controllers 50A, 50B, 50C a conveyance instruction to cause a transport vehicle 6 to convey an article 10. In the present embodiment, the host controller 60 outputs to any one of the area controllers 50A, 50B, 50C a conveyance instruction (the conveyance source of which is a placement unit 8) to convey an article 10 placed on the placement unit 8 to another predetermined placement unit 8.

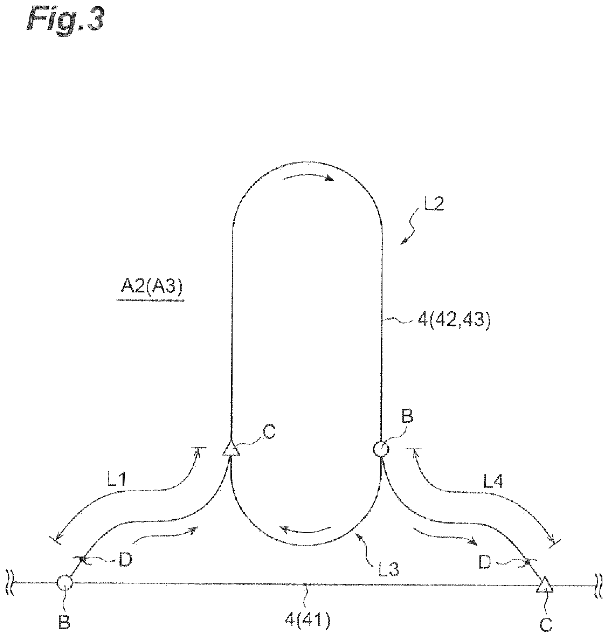

In FIG. 1, a layout of the track 4 according to the present embodiment is illustrated. In the present embodiment, the track 4 forms intra-bay traveling paths 42, 43 respectively arranged in the areas A2, A3 and one inter-bay traveling path 41 that allows the two intra-bay traveling paths 42, 43 to communicate with each other so that transport vehicles 6 can travel therebetween. The intra-bay traveling paths 42, 43 and the inter-bay traveling path 41 are set such that transport vehicles 6 travel in one direction clockwise (directions indicated by arrows in FIG. 1 and FIG. 3).

Herein, in the predetermined traveling direction of the transport vehicles 6, when a location where a track 4 branches off is a branch portion B, a location where tracks 4 merge is a merging portion C, and a boundary between areas is a boundary portion D, a track portion that is interposed between any pair among the branch portion B, the merging portion C, and the boundary portion D is defined as a "section".

In the system as described above, in which various operations of the transport vehicles 6 that are present in the areas A1, A2, A3 are controlled respectively by the area controllers 50A, 50B, 50C, in one area, a section that cannot be entered without passing through another area that is different from the one area exists. Such a section is defined as "special section". In the layout of the track 4 illustrated in FIG. 1, a section in the area A2, that cannot be entered without passing through the other area A1 different from the area A2 (section extending from a boundary portion D to the merging portion C in the traveling direction of the transport vehicles 6), and a section in the area A3, that cannot be entered without passing through the other area A1 different from the area A3 (section extending from a boundary portion D to the merging portion C in the traveling direction of the transport vehicles 6), correspond to special sections (see FIG. 3).

As illustrated in FIG. 3, in each of the areas A2, A3, in the traveling direction of the transport vehicles 6, a section L2 extending from a merging portion C to a branch portion B, a section L3 extending from the branch portion B to the merging portion C, and a section L4 extending from the branch portion B to a boundary portion D exist. The sections L2, L3, L4 are configured so as to be able to be entered from another section in the same area. For example, in the area A2, the section L2 can be entered from both the section L1 and the section L3 in the same area A2. The section L3 and the section L4 can be entered from the section L2 in the same area A2. In the present embodiment, the sections L2, L3, L4 are defined as non-special sections.

In the section L1 that is a special section in each of the areas A2, A3 (hereinafter, called "special section L1"), placement units 8 disposed along this section exist. As illustrated in FIG. 1, in the present embodiment, three placement units 8, 8, 8 exist. In the present embodiment, these placement units 8 belonging to the special section L1 are referred to as special placement units 80A, 80B, 80C from the upstream in the predetermined traveling direction of the transport vehicles 6.

The following describes operation of the area controllers 50B, 50C in the above-described layout of the track 4. The area controller 50B (50C), when having received from the host controller 60 a conveyance instruction (the conveyance source of which is the special placement unit 80C) to convey to a predetermined placement unit 8 an article 10 placed on one special placement unit (e.g., 80C) of the own jurisdiction area A2 (A3) that is its own jurisdiction area, transmits a movement instruction to cause a transport vehicle 6 that is empty to move toward the own jurisdiction area A2 (A3) to the other area controller 50A configured to control a transport vehicle 6 in the area A1 that is adjacent to the special section L1 where the special placement unit 80C is positioned. Herein, the transport vehicle 6 that is empty (hereinafter, called "empty transport vehicle 6") indicates a transport vehicle that is loaded with (holds) no article 10 and can be loaded with an article 10.

The area controller 50B (50C) in the present embodiment detects whether an empty transport vehicle 6 is present in the own jurisdiction area A2 (A3) and upstream of the one special placement unit 80C before transmitting the movement instruction to the other area controller 50A. The area controller 50B (50C) transmits the above-described movement instruction to the area controller 50A only when an empty transport vehicle 6 is not present in the own jurisdiction area A2 (A3) or upstream of the one special placement unit 80C. If an empty transport vehicle 6 is present in the own jurisdiction area A2 (A3) and upstream of the one special placement unit 80C, the area controller 50B (50C) causes this empty transport vehicle 6 to execute the conveyance instruction.

If having detected that an empty transport vehicle 6 has become available in the own jurisdiction area A2 (A3) after transmission of the above-described movement instruction, the area controller 50B (50C) causes the empty transport vehicle 6 in the own jurisdiction area A2 (A3) to execute the conveyance instruction. The expression "after transmission" herein includes a meaning of "at substantially the same time" . In such a situation, candidates for an empty transport vehicle 6 in the own jurisdiction area A2(A3) to be detected after transmission of the movement instruction by the area controller 50B (50C) include an empty transport vehicle 6 that enters the own jurisdiction area A2 (A3) from the other jurisdiction area A1 and an empty transport vehicle 6 that becomes available by placing an article 10 onto a placement unit 8 belonging to the own jurisdiction area A2 (A3) (by completing a conveyance instruction) . After causing the empty transport vehicle 6 that has become available in the own jurisdiction area A2 (A3) to execute the conveyance instruction, the area controller 50B (50C) transmits to the other area controller 50A an instruction to delete the movement instruction transmitted to the other area controller 50A.

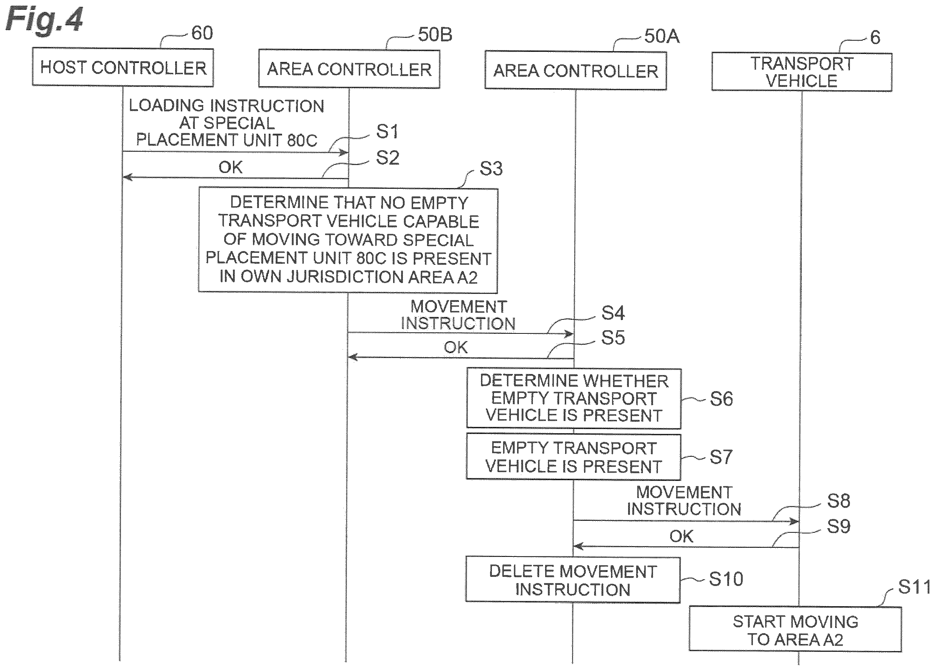

The following describes one example of processes performed by the transport vehicle system 1 specifically with reference to sequence diagrams in FIG. 4 to FIG. 7. Herein, processes when a conveyance instruction (the conveyance source of which is the special placement unit 80C) to convey an article 10 placed on the special placement unit 80C in the area A2 to a predetermined placement unit 8 will be described. In the following, a procedure of operation of the one area controller 50B among the area controllers 50A, 50B, 50C will be described.

As illustrated in FIG. 4, the host controller 60 transmits, as a conveyance instruction, a loading instruction at the special placement unit 80C in the area A2 to the area controller 50B having jurisdiction over the area A2 (step S1). The area controller 50B, when having received the loading instruction from the host controller 60, transmits to the host controller 60 a signal to notify it of having received the loading instruction (step S2). The area controller 50B detects whether an empty transport vehicle 6 capable of moving toward the special placement unit 80C is present in the own jurisdiction area A2 (step S3). Hereinafter, description is made on the assumption that such an empty transport vehicle 6 has been determined to be absent in the own jurisdiction area A2.

The area controller 50B transmits a movement instruction destined for the area A2 to the area controller 50A having jurisdiction over the area A1 that is different from the own jurisdiction area A2 (step S4). The area controller 50A, when having received the movement instruction from the area controller 50B, transmits to the area controller 50B a signal to notify it of having received the movement instruction (step S5). The area controller 50A determines whether an empty transport vehicle 6 is present in the own jurisdiction area A1 (step S6). The area controller 50A continuously communicates with all transport vehicles 6 that are present in the own jurisdiction area A1 at predetermined intervals (e.g., several times per second), and receives a status report from each transport vehicle 6. The area controller 50A always grasps the states of all the transport vehicles 6 based on such status reports, and thus can determine whether an empty transport vehicle 6 is present in the own jurisdiction area A1.

The following describes a case when the area controller 50A has determined that an empty transport vehicle 6 is present in the own jurisdiction area A1 (step S7). A case when the area controller 50A has determined that no empty transport vehicle 6 is present will be described later in detail.

If having determined that an empty transport vehicle 6 is present in the own jurisdiction area A1, the area controller 50A transmits to this empty transport vehicle 6 a movement instruction to move toward the area A2 (step S8) . The transport vehicle 6, when having received the movement instruction from the area controller 50A, transmits to the area controller 50A a signal to notify it of having received the movement instruction (step S9), and starts moving toward the area A2 (step S11). The area controller 50A, when having received the signal to notify it of having received the movement instruction from the transport vehicle 6, deletes the movement instruction stored in a memory (not illustrated) that the area controller 50A includes (step S10).

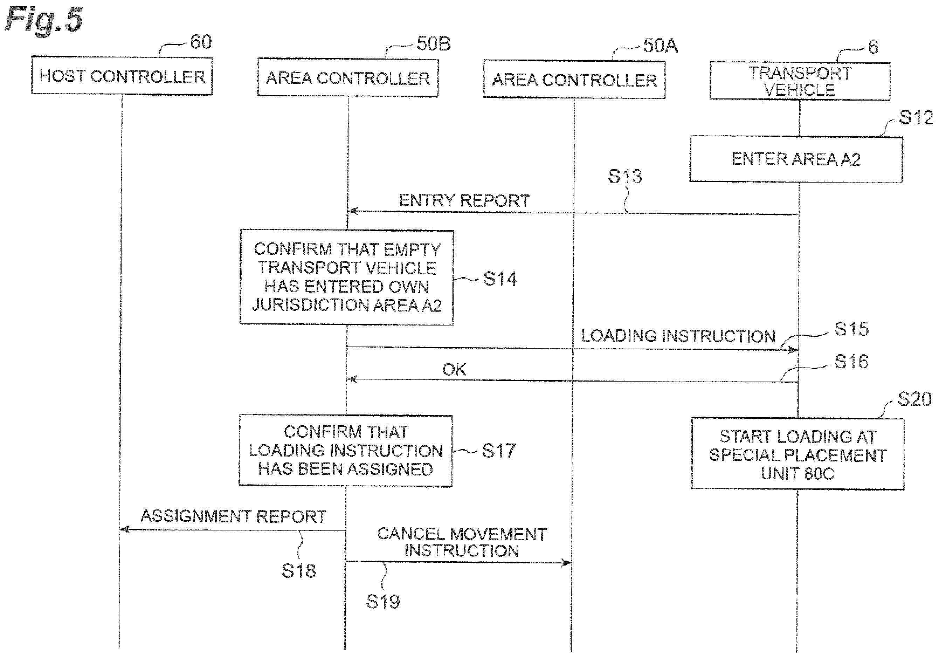

As illustrated in FIG. 5, the transport vehicle 6 executes the movement instruction transmitted at step S8, thereby entering the area A2 (step S12). The transport vehicle 6 assigned with the movement instruction transmits a request for entry into the area A2 to the area controller 50A. The area controller 50A communicates with the area controller 50B, and also transmits an entry permission to the transport vehicle 6. The transport vehicle 6 enters the area A2 and transmits an entry report to the area controller 50B (step S13), and the area controller 50B confirms (is notified) that the transport vehicle 6 has entered (step S14). The entry report into the area A2 is also transmitted to the area controller 50A via the area controller 50B.

The area controller 50B, when having confirmed that the empty transport vehicle 6 has entered the own jurisdiction area A2, transmits an instruction to be loaded with the article 10 placed on the special placement unit 80C to the transport vehicle 6 that has entered the area A2 (step S15). The transport vehicle 6, when having received this loading instruction from the area controller 50B, transmits to the area controller 50B a signal to notify it of having received the loading instruction (step S16), and continues moving toward the special placement unit 80C. The transport vehicle 6 that has reached the special placement unit 80C is loaded with the article 10 placed on the special placement unit 80C, and conveys it to the specified place (step S20). Herein, in the conveyance instruction including the loading instruction, information on a conveyance destination of the article 10 is included.

The area controller 50B receives the signal to notify it of having received the loading instruction from the transport vehicle 6, thereby confirming that the loading instruction has been assigned to the transport vehicle 6 (step S17). Subsequently, the area controller 50B transmits an assignment report to the host controller 60 (step S18), and also causes the area controller 50A to cancel the movement instruction transmitted thereto (step S19). In the present embodiment, because the movement instruction stored in the memory of the area controller 50A has already been deleted in the process at step 510, no process will be performed in accordance with the movement instruction at step S19. Thus, a series of processes when a conveyance instruction to convey the article 10 placed on the special placement unit 80C in the area A2 to the predetermined placement unit 8 has been issued ends.

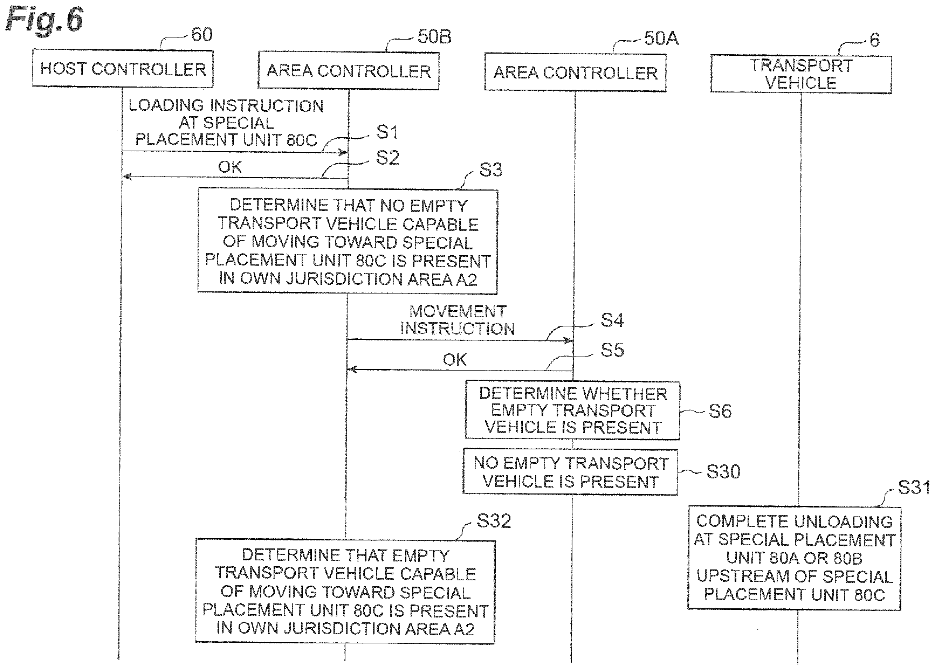

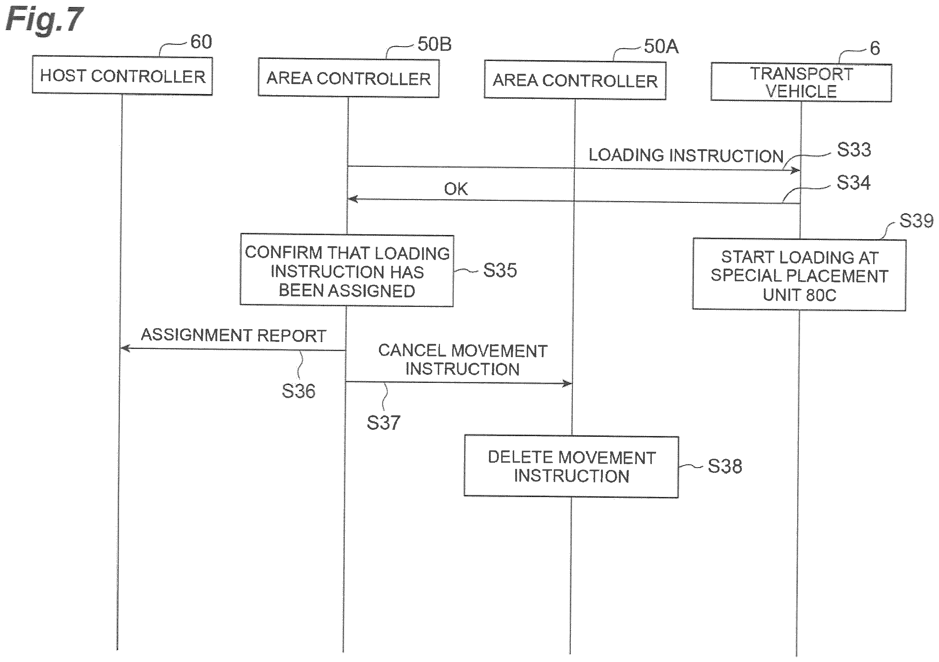

The following describes a case when the area controller 50A has determined at step S6 that no empty transport vehicle 6 is present with reference to FIG. 6 and FIG. 7. Because processes up to step S6 are the same as those described above, duplicate description is omitted. As illustrated in FIG. 6, the area controller 50A, if having determined that no empty transport vehicle 6 is present in the own jurisdiction area A1 (step S30), cannot issue a movement instruction to a transport vehicle 6. Thus, the area controller 50A continues monitoring the own jurisdiction area A1 with the movement instruction being stored in the memory thereof.

Herein, at the special placement unit 80A or 80B upstream of the special placement unit 80C in the area A2, when a transport vehicle 6 has been unloaded with an article 10 (step S31), this empty transport vehicle 6 newly becomes available in the area A2, and thus an empty transport vehicle 6 becomes present. Thus, the area controller 50B monitoring the area A2 determines that an empty transport vehicle 6 capable of moving toward the special placement unit 80C is present in the own jurisdiction area A2 (step S32).

As illustrated in FIG. 7, the area controller 50B transmits a loading instruction at the special placement unit 80C to the empty transport vehicle 6 that has newly become available in the area A2 (step S33) . The transport vehicle 6, when having received the loading instruction from the area controller 50B, transmits a signal to notify it of having received the loading instruction to the area controller 50B (step S34), and starts moving toward the special placement unit 80C. The transport vehicle 6 that has reached the special placement unit 80C is loaded with the article 10 placed on the special placement unit 80C, and conveys it to the specified place (step S39). Herein, in the conveyance instruction including the loading instruction, information on a conveyance destination of the article 10 is included.

The area controller 50B, having received the signal to notify it of having received the loading instruction from the transport vehicle 6, confirms that the loading instruction has been assigned to the transport vehicle 6 (step S35). Subsequently, the area controller 50B transmits an assignment report to the host controller 60 (step S36), and also causes the area controller 50A to cancel the movement instruction (step S37). In other words, the movement instruction stored in the memory of the area controller 50A is deleted (step S38) . Thus, a series of processes when a conveyance instruction to convey the article 10 placed on the special placement unit 80C in the area A2 to the predetermined placement unit 8 has been issued ends.

Although detailed description is omitted, the area controller 50C also uses the same procedure of operation as that of the area controller 50B.

The following describes functional effects of the transport vehicle system 1 according to the embodiment described above. A transport vehicle system 1 in which the area controllers 50A, 50B, 50C respectively consider the areas A1, A2, A3 as the jurisdiction areas A1, A2, A3 control various operations of transport vehicles 6 has problems described below. Specifically, each area controller 50B (50C) of such a transport vehicle system 1, even when having received a conveyance instruction destined for the special placement unit 80C in the own jurisdiction area A2 (A3), cannot cause a transport vehicle 6 to move to the special placement unit 80C to be loaded in most cases. Thus, a conventional host controller 60 was used to transmit the conveyance instruction to the other area controller 50A having jurisdiction over the other area A1, and this other area controller 50A was used to cause an empty transport vehicle 6 in the jurisdiction area A1 to execute the conveyance instruction.

However, in this case, even if an empty transport vehicle 6 has become available in the special section L1 of the area A2 (A3) before a transport vehicle 6 in the other jurisdiction area A1 reaches the special placement unit 80C, the other area controller 50A that has received the conveyance instruction cannot control the transport vehicle 6 that has become available in the area A2 over which it has no jurisdiction. Thus, the transport vehicle 6 in the own jurisdiction area A2 (A3) has to pass by the special placement unit 80C even though it is not loaded with an article 10 (it is empty). This causes a problem in which the conveyance efficiency deteriorates and the handling time increases.

In the transport vehicle system 1 according to the embodiment described above, when a conveyance instruction the conveyance source of which is the special placement unit 80C in the area A2 (A3) has been issued, the host controller 60 transmits the conveyance instruction to the area controller 50B (50C) having jurisdiction over the area A2 (A3) to which the special placement unit 80C belongs first, instead of transmitting the conveyance instruction to the other area controller 50A to which the special placement unit 80C does not belong. The area controller 50B (50C) that has received the conveyance instruction transmits, to the other area controller 50A, a movement instruction to cause an empty transport vehicle 6 to move toward the area A2. By these processes, the area controller 50B (50C) having jurisdiction over the area A2 (A3) to which the special placement unit 80C belongs can be given room to cause a transport vehicle 6 to execute the conveyance instruction, whereby the conveyance instruction can be assigned to both of a transport vehicle 6 (a transport vehicle 6 in the other jurisdiction area A1)) that is going to enter the area A2 (A3) in accordance with the preceding movement instruction and an empty transport vehicle 6 that becomes available in the area A2 (A3). Consequently, deterioration of the conveyance efficiency described above can be eliminated, and thus even when a conveyance instruction the conveyance source of which is a placement unit belonging to the special section L1 has been issued, this conveyance instruction can be handled efficiently.

In the transport vehicle system 1 according to the embodiment described above, the area controller 50B (50C) deletes the movement instruction transmitted to the area controller 50A after causing the empty transport vehicle 6 that has become available in the own jurisdiction area A2 (A3) to execute the conveyance instruction. By this process, at the time when an empty transport vehicle 6 has become available in the area A2 (A3), movement of an empty transport vehicle 6 traveling toward the own jurisdiction area A2 (A3) can be canceled, and thus influence on the conveying capability in the other area A1 can be minimized.

In the transport vehicle system 1 according to the embodiment described above, the area controller 50B (50C) detects whether an empty transport vehicle 6 is present in the own jurisdiction area A2 (A3) before transmitting the movement instruction to the area controller 50A. By this process, before transmitting the movement instruction to the other area controller 50A, necessity thereof can be checked, and thus influence on the conveying capability in the other area A1 can be minimized.

In the transport vehicle system 1 according to the embodiment described above, the area controller 50B (50C) detects whether an empty transport vehicle 6 is present in the own jurisdiction area A2 (A3) and upstream of the one special placement unit 80C before transmitting the movement instruction to the other area controller 50A. By this process, check range of the necessity to transmit the movement instruction to the other area controller 50A can be minimized, whereby the handling speed can be improved.

In the embodiment, an example of a control performed in the layout of the track 4 as illustrated in FIG. 1 has been described. However, the layout is not limited to this. The aspect of the present invention may be applied to any layout of the track 4 if the layout of the track 4 has a special section L1.

In the embodiment, an example has been described in which the area controller 50B (50C), when having received from the host controller 60 a conveyance instruction destined for the one special placement unit 80C in the own jurisdiction area A2 (A3), transmits a movement instruction to the one area controller 50A. However, the area controller 50B (50C) may transmit the movement instruction to a plurality of other area controllers. This modification is effective for, for example, a layout in which a merging portion is arranged at a position closer to the starting point of each special section L1. Herein, even if the layout in which a merging portion is arranged at a position closer to the starting point of each special section L1 is used, the movement instruction may be transmitted to a predetermined one of the other area controllers. Furthermore, the area controller 50B (50C) may transmit the movement instruction to area controllers having jurisdiction over not only the adjacent areas but also areas that are adjacent to the adjacent areas. This modification is effective for, for example, a case when the number of empty transport vehicles is small.

In the embodiment, an example has been described in which the area controller 50B (50C) transmits the movement instruction to the area controller 50A only when an empty transport vehicle 6 is not present in the own jurisdiction area A2 (A3) or upstream of the one special placement unit 80C. However, the present invention is not limited to this. For example, the area controller 50B (50C) may transmit the movement instruction to the other area controller 50A without confirming that an empty transport vehicle 6 is present in the own jurisdiction area A2 (A3) and upstream of the one special placement unit 80C. Even in this case, the movement instruction is deleted as soon as an empty transport vehicle 6 is found in the own jurisdiction area A2 (A3), and thus influence on the other area A1 can be reduced to a minimum.

The transport vehicle system 1 according to the embodiment and the modifications has been described in which the traveling vehicles are transport vehicles 6 as one example. However, other examples of the traveling vehicles include automated guided traveling vehicles and stacker cranes configured to travel on a track installed on the ground or abutments.

### Reference Signs List

1 ... transport vehicle system, 4 ... track, 6 ... overhead transport vehicle (transport vehicle), 8 ... placement unit, 8A ... buffer, 8B ... delivery port, 80A, 80B, 80C ... special placement unit, 10 ... article, 41 ... inter-bay traveling path, 42, 43 ... intra-bay traveling path, 50A, 50B, 50C ... area controller, 60 ... host controller, A1, A2, A3 ... area, B ... branch portion, C ... merging portion, D ... boundary portion, L1 ... special section

## Claims

1. A transport vehicle system (1) comprising:
a track (4) provided in a manner extending over a plurality of areas (A1, A2, A3);
a plurality of transport vehicles (6) configured to travel in one direction along the track (4);
a plurality of placement units (8, 80A, 80B, 80C) disposed along the track (4) and configured for each transport vehicle (6) to deliver or receive an article to or from the placement units (8, 80A, 80B, 80C); and
a plurality of area controllers (50A, 50B, 50C) each configured to receive, from a host controller (60), a conveyance instruction to convey an article placed on one of the placement units (8, 80A, 80B, 80C) in one of the areas (A1, A2, A3) representing a jurisdiction area (A1, A2, A3) associated with an area controller (50A, 50B, 50C), and cause a transport vehicle (6) in the jurisdiction area to execute various instructions,
wherein a placement unit (80A, 80B, 80C) belonging to a special section in one of the jurisdiction areas (A2, A3), which is a section that is unable to be entered without passing through another jurisdiction area (A1) different from the one jurisdiction area (A2, A3), represents a special placement unit (80A, 80B, 80C),
wherein each area controller (50B, 50C), when having received from the host controller (60) a conveyance instruction destined for a special placement unit (80A, 80B, 80C) belonging to the own jurisdiction area (A2, A3) that is the jurisdiction area (A2, A3) associated with the area controller (50B, 50C), is configured to
when an empty transport vehicle (6) is not present in the own jurisdiction area, transmit to another area controller (50A) amovement instruction to cause an empty transport vehicle (6) to move toward the own jurisdiction area (A2, A3), the other area controller (50A) being configured to control the empty transport vehicle (6) in a jurisdiction area (A1) associated with the other area controller (50A), and also to cause an empty transport vehicle (6) that has become available in the own jurisdiction area (A2, A3) after transmission of the movement instruction to execute the conveyance instruction.

2. The transport vehicle system (1) according to claim 1, wherein the empty transport vehicle (6) in the own jurisdiction area (A2, A3) which is to be detected by the area controller (50B, 50C) after the transmission of the movement instruction is an empty transport vehicle (6) that enters the own jurisdiction area (A2, A3) from the other jurisdiction area (A1) or an empty transport vehicle (6) that becomes available by placing an article onto a special placement unit (80A, 80B, 80C) belonging to the own jurisdiction area (A12, A3).

3. The transport vehicle system (1) according to claim 1 or 2, wherein the area controller (50B, 50C), which has transmitted the movement instruction to the other are controller (50A), is configured to transmit to the other area controller (50A) an instruction to cancel the movement instruction transmitted to the other area controller (50A) after causing the empty transport vehicle (6) that has become available in the own jurisdiction area (A2, A3) to execute the conveyance instruction.

4. The transport vehicle system (1) according to any one of claims 1 to 3, wherein the area controller (50B, 50C), which has transmitted the movement instruction to the other are controller (50A), is configured to detect whether an empty transport vehicle (6) is present in the own jurisdiction area (A2, A3) before transmitting the movement instruction to the other area controller (50A).

5. The transport vehicle system (1) according to claim 4, wherein the area controller (50B, 50C), which has transmitted the movement instruction to the other are controller (50A), is configured to detect whether an empty transport vehicle (6) is present in the own jurisdiction area (A2, A3) and upstream of the special placement unit (80A, 80B, 80C) in a traveling direction, in which transport vehicles move along the track (4), before transmitting the movement instruction to the other area controller (50A).

## Patentansprüche

1. Ein Transportfahrzeugsystem (1), das folgende Merkmale aufweist:
eine Bahn (4), die in einer Weise vorgesehen ist, die sich über eine Mehrzahl von Bereichen (A1, A2, A3) erstreckt;
eine Mehrzahl von Transportfahrzeugen (6), die dazu ausgebildet sind, sich in einer Richtung entlang der Bahn (4) zu bewegen;
eine Mehrzahl von Platzierungseinheiten (8, 80A, 80B, 80C), die entlang der Bahn (4) angeordnet und für jedes Transportfahrzeug (6) dazu ausgebildet sind, einen Gegenstand an die Platzierungseinheiten (8, 80A, 80B, 80C) zu liefern oder von diesem zu empfangen; und
eine Mehrzahl von Bereichssteuerungen (50A, 50B, 50C), die jeweils dazu ausgebildet sind, von einer Host-Steuerung (60) einen Beförderungsbefehl zu empfangen, um einen Gegenstand, der auf einer der Platzierungseinheiten (8, 80A, 80B, 80C) in einem der Bereiche (A1, A2, A3), der einen Zuständigkeitsbereich (A1, A2, A3) darstellt, der einer Bereichssteuerung (50A, 50B, 50C) zugeordnet ist, zu befördern und zu bewirken, dass ein Transportfahrzeug (6) in dem Zuständigkeitsbereich verschiedene Befehle ausführt,
wobei eine Platzierungseinheit (80A, 80B, 80C), die zu einem speziellen Abschnitt in einem der Zuständigkeitsbereiche (A2, A3) gehört, der ein Abschnitt ist, in den nicht gelangt werden kann, ohne durch einen weiteren Zuständigkeitsbereich (A1) zu laufen, der sich von dem einen Zuständigkeitsbereich (A2, A3) unterscheidet, eine spezielle Platzierungseinheit (80A, 80B, 80C) darstellt,
wobei jede Bereichssteuerung (50B, 50C), wenn sie von der Host-Steuerung (60) einen Beförderungsbefehl empfangen hat, der für eine spezielle Platzierungseinheit (80A, 80B, 80C) gedacht ist, die zu dem eigenen Zuständigkeitsbereich (A2, A3) gehört, der der Zuständigkeitsbereich (A2, A3) ist, der der Bereichssteuerung (50B, 50C) zugeordnet ist, dazu ausgebildet ist:
wenn kein leeres Transportfahrzeug (6) in dem eigenen Zuständigkeitsbereich vorliegt, an eine weitere Bereichssteuerung (50A) einen Bewegungsbefehl zu übertragen, um zu bewirken, dass ein leeres Transportfahrzeug (6) sich in Richtung des eigenen Zuständigkeitsbereichs (A2, A3) bewegt, wobei die andere Bereichssteuerung (50A) dazu ausgebildet ist, das leere Transportfahrzeug (6) in einem Zuständigkeitsbereich (A1) zu steuern, der der anderen Bereichssteuerung (50A) zugeordnet ist, und außerdem zu bewirken, dass ein leeres Transportfahrzeug (6), das in dem eigenen Zuständigkeitsbereich (A2, A3) nach Übertragung des Bewegungsbefehls verfügbar geworden ist, den Beförderungsbefehl ausführt.

2. Das Transportfahrzeugsystem (1) gemäß Anspruch 1, bei dem das leere Transportfahrzeug (6) in dem eigenen Zuständigkeitsbereich (A2, A3), der durch die Bereichssteuerung (50B, 50C) nach der Übertragung des Bewegungsbefehls erfasst werden soll, ein leeres Transportfahrzeug (6) ist, das von dem anderen Zuständigkeitsbereich (A1) in den eigenen Zuständigkeitsbereich (A2, A3) gelangt, oder ein leeres Transportfahrzeug (6), das verfügbar wird durch Platzieren eines Gegenstands auf einer speziellen Platzierungseinheit (80A, 80B, 80C), die zu dem eigenen Zuständigkeitsbereich (A2, A3) gehört.

3. Das Transportfahrzeugsystem (1) gemäß Anspruch 1 oder 2, bei dem die Bereichssteuerung (50B, 50C), die den Bewegungsbefehl an die andere Bereichssteuerung (50A) übertragen hat, dazu ausgebildet ist, an die andere Bereichssteuerung (50A) einen Befehl zu übertragen, um den Bewegungsbefehl, der an die andere Bereichssteuerung (50A) übertragen wurde, aufzuheben, nachdem bewirkt wurde, dass das leere Transportfahrzeug (6), das in dem eigenen Zuständigkeitsbereich (A2, A3) verfügbar geworden ist, den Beförderungsbefehl ausführt.

4. Das Transportfahrzeugsystem (1) gemäß einem der Ansprüche 1 bis 3, bei dem die Bereichssteuerung (50B, 50C), die den Bewegungsbefehl an die andere Bereichssteuerung (50A) übertragen hat, dazu ausgebildet ist, zu erfassen, ob ein leeres Transportfahrzeug (6) in dem eigenen Zuständigkeitsbereich (A2, A3) vorhanden ist, bevor der Bewegungsbefehl an die andere Bereichssteuerung (50A) übertragen wird.

5. Das Transportfahrzeugsystem (1) gemäß Anspruch 4, bei dem die Bereichssteuerung (50B, 50C), die den Bewegungsbefehl an die andere Bereichssteuerung (50A) übertragen hat, dazu ausgebildet ist, zu erfassen, ob ein leeres Transportfahrzeug (6) in dem eigenen Zuständigkeitsbereich (A2, A3) und in Verarbeitungsrichtung vor der speziellen Platzierungseinheit (80A, 80B, 80C) in einer Bewegungsrichtung vorhanden ist, in der sich Transportfahrzeuge entlang der Bahn (4) bewegen, bevor der Bewegungsbefehl an die andere Bereichssteuerung (50A) übertragen wird.

## Revendications

1. Système de véhicules de transport (1) comprenant:
une piste (4) prévue de manière à s'étendre sur une pluralité de zones (A1, A2, A3);
une pluralité de véhicules de transport (6) configurés pour se déplacer dans une direction le long de la piste (4);
une pluralité d'unités de placement (8, 80A, 80B, 80C) disposées le long de la piste (4) et configurées pour que chaque véhicule de transport (6) délivre ou reçoive un article vers ou depuis les unités de placement (8, 80A, 80B, 80C); et
une pluralité de moyens de commande de zone (50A, 50B, 50C) configurés, chacun, pour recevoir, d'un moyen de commande hôte (60), une instruction de transport pour transporter un article placé sur l'une des unités de placement (8, 80A, 80B, 80C) dans une des zones (A1, A2, A3) représentant une zone de juridiction (A1, A2, A3) associée à un moyen de commande de zone (50A, 50B, 50C), et pour amener un véhicule de transport (6) dans la zone de juridiction à exécuter diverses instructions,
dans lequel une unité de placement (80A, 80B, 80C) appartenant à un segment spécial dans l'une des zones de juridiction (A2, A3), qui est un segment dans lequel il est impossible d'entrer sans passer par une autre zone de juridiction (A1) différente de l'une zone de juridiction (A2, A3), représente une unité de placement spéciale (80A, 80B, 80C),
dans lequel chaque moyen de commande de zone (50B, 50C), après avoir reçu du moyen de commande hôte (60), une instruction de transport destinée à une unité de placement spéciale (80A, 80B, 80C) appartenant à la propre zone de juridiction (A2, A3), qui est la zone de juridiction (A2, A3) associée au moyen de commande de zone (50B, 50C), est configuré pour
lorsqu'un véhicule de transport vide (6) n'est pas présent dans la propre zone de juridiction, transmettre à un autre moyen de commande de zone (50A) une instruction de déplacement pour amener un véhicule de transport vide (6) à se déplacer vers la propre zone de juridiction (A2, A3), l'autre moyen de commande de zone (50A) étant configuré pour commander le véhicule de transport vide (6) dans une zone de juridiction (A1) associée à l'autre moyen de commande de zone (50A), et également pour amener un véhicule de transport vide (6) qui est devenu disponible dans la propre zone de juridiction (A2, A3) après la transmission de l'instruction de déplacement à exécuter l'instruction de transport.

2. Système de véhicule de transport (1) selon la revendication 1, dans lequel le véhicule de transport vide (6) dans la propre zone de juridiction (A2, A3) qui doit être détecté par le moyen de commande de zone (50B, 50C) après la transmission de l'instruction de déplacement est un véhicule de transport vide (6) qui entre dans la propre zone de juridiction (A2, A3) depuis l'autre zone de juridiction (A1) ou un véhicule de transport vide (6) qui devient disponible en plaçant un article sur une unité de placement spéciale (80A, 80B, 80C) appartenant à la propre zone de juridiction (A12, A3).

3. Système de véhicule de transport (1) selon la revendication 1 ou 2, dans lequel le moyen de commande de zone (50B, 50C) qui a transmis l'instruction de déplacement à l'autre moyen de commande de zone (50A) est configuré pour transmettre à l'autre moyen de commande de zone (50A) une instruction pour annuler l'instruction de déplacement transmise à l'autre moyen de commande de zone (50A) après avoir amené le véhicule de transport vide (6) qui est devenu disponible dans la propre zone de juridiction (A2, A3) à exécuter l'instruction de transport.

4. Système de véhicule de transport (1) selon l'une quelconque des revendications 1 à 3, dans lequel le moyen de commande de zone (50B, 50C) qui a transmis l'instruction de déplacement à l'autre moyen de commande (50A) est configuré pour détecter si un véhicule de transport vide (6) est présent dans la propre zone de juridiction (A2, A3) avant de transmettre l'instruction de déplacement à l'autre moyen de commande de zone (50A).

5. Système de véhicule de transport (1) selon la revendication 4, dans lequel le moyen de commande de zone (50B, 50C) qui a transmis l'instruction de déplacement à l'autre moyen de commande de zone (50A) est configuré pour détecter si un véhicule de transport vide (6) est présent dans la propre zone de compétence (A2, A3) et en amont de l'unité de placement spéciale (80A, 80B, 80C) dans une direction de circulation dans laquelle les véhicules de transport se déplacent le long de la piste (4), avant de transmettre l'instruction de déplacement à l'autre moyen de commande de zone (50A).
